# EUROPEAN PATENT APPLICATION

(11) **EP 4 808 119 A1**
(43) Date of publication of application: **16.09.2026**
(21) Application number: 25199418.2
(22) Date of filing: 01.09.2025
(51) Int. Cl.: H04N 19/13, H03M 7/40, H03M 7/42, H03M 7/30

(54) **COMPRESSION DEVICE AND MEMORY SYSTEM**

(30) Priority: 10.03.2025 JP 2025037373
(71) Applicant: Kioxia Corporation, Tokyo 108-0023 (JP)
(72) Inventor: Takasaki, Yosei, Tokyo (JP); Nakanishi, Keiri, Tokyo (JP); Kodama, Sho, Tokyo (JP); Sumiyoshi, Masato, Tokyo (JP)
(74) Representative: Marks & Clerk LLP

(57) **Abstract**

According to one embodiment, a compression device (15) compresses data of a size corresponding to a compression unit (C). The compression device (15) includes circuitry (22). The circuitry (22) is configured to generate an entropy encoding unit (H[n]) that is a unit of data to be subjected to entropy encoding at a time based on the compression unit (C), select one of dynamic entropy encoding and static entropy encoding as a scheme of entropy encoding performed on data corresponding to the entropy encoding unit (H[n]), perform the dynamic entropy encoding on entropy encoding target data when the dynamic entropy encoding is selected, and perform the static entropy encoding on the entropy encoding target data when the static entropy encoding is selected.

## Description

### CROSS-REFERENCE TO RELATED APPLICATIONS

This application is based upon and claims the benefit of priority from Japanese Patent Application No. 2025-037373, filed March 10, 2025.

### FIELD

Embodiments described herein relate generally to a compression device and a memory system.

### BACKGROUND

There are two methods of entropy encoding, that is, dynamic entropy encoding and static entropy encoding.

The dynamic entropy encoding generates an entropy encoding table for each data which is a target of entropy encoding, and performs encoding by using the generated entropy encoding table, and thus has a feature that high encoding efficiency can be obtained, while latency required for generating the entropy encoding table is increased.

Meanwhile, since the static entropy encoding performs encoding using an entropy encoding table prepared in advance, the static entropy encoding has a feature that the encoding efficiency is low while the latency required for encoding is small.

In such a compression device that performs entropy encoding, there is a case where both the dynamic entropy encoding and the static entropy encoding described above are performed on data corresponding to an entropy encoding unit that is a unit of data to be subjected to entropy encoding at a time, and a result of entropy encoding having a small code amount (data amount) is selected and output to compress the data.

In this case, when the dynamic entropy encoding is performed in a case where the entropy encoding unit is small, the latency required for generating the entropy encoding table becomes relatively longer than the latency required for encoding (encoding of a payload) data which is target of the entropy encoding, and the compression throughput decreases.

Furthermore, in a case of decoding the result of the dynamic entropy encoding performed in a case where the entropy encoding unit is small, the latency required for restoring the entropy encoding table becomes relatively longer than the latency required for decoding (decoding of the payload) the result of the dynamic entropy encoding, and the decompression throughput decreases.

### BRIEF DESCRIPTION OF THE DRAWINGS

FIG. 1 is a diagram illustrating an example of a configuration of an information processing system including a compression device according to a first embodiment.
FIG. 2 is a block diagram illustrating an example of a configuration of a compression device according to a comparative embodiment of the first embodiment.
FIG. 3 is a diagram for explaining a decrease in compression throughput that can occur in the compression device according to the comparative example of the first embodiment.
FIG. 4 is a diagram for explaining a decrease in the decompression throughput that can occur in the compression device according to the comparative example of the first embodiment.
FIG. 5 is a block diagram illustrating an example of a configuration of the compression device according to the first embodiment.
FIG. 6 is a flowchart illustrating an example of a procedure of encoding unit generation processing by an entropy encoding unit generating circuit according to the first embodiment.
FIG. 7 is a diagram for describing an outline of the encoding unit generation processing by the entropy encoding unit generating circuit according to the first embodiment.
FIG. 8 is a flowchart illustrating an example of a procedure of encoding scheme selection processing by an encoding scheme selecting circuit according to the first embodiment.
FIG. 9 is a flowchart illustrating an example of a procedure of encoding unit generation processing by an entropy encoding unit generating circuit according to a second embodiment.
FIG. 10 is a diagram for describing an outline of the encoding unit generation processing by the entropy encoding unit generating circuit according to the second embodiment.
FIG. 11 is a flowchart illustrating an example of a procedure of encoding unit generation processing by an entropy encoding unit generating circuit according to a third embodiment.

### DETAILED DESCRIPTION

In general, according to one embodiment, a compression device compresses data of a size corresponding to a compression unit. The compression device includes circuitry. The circuitry is configured to generate an entropy encoding unit that is a unit of data to be subjected to entropy encoding at a time based on the compression unit. The circuitry is configured to select one of dynamic entropy encoding and static entropy encoding as a scheme of entropy encoding performed on data corresponding to the entropy encoding unit based on the entropy encoding unit. The circuitry is configured to perform the dynamic entropy encoding on entropy encoding target data that is a target of the entropy encoding when the dynamic entropy encoding is selected. The circuitry is configured to perform the static entropy encoding on the entropy encoding target data when the static entropy encoding is selected.

Hereinafter, embodiments will be described with reference to the drawings.

### (First Embodiment)

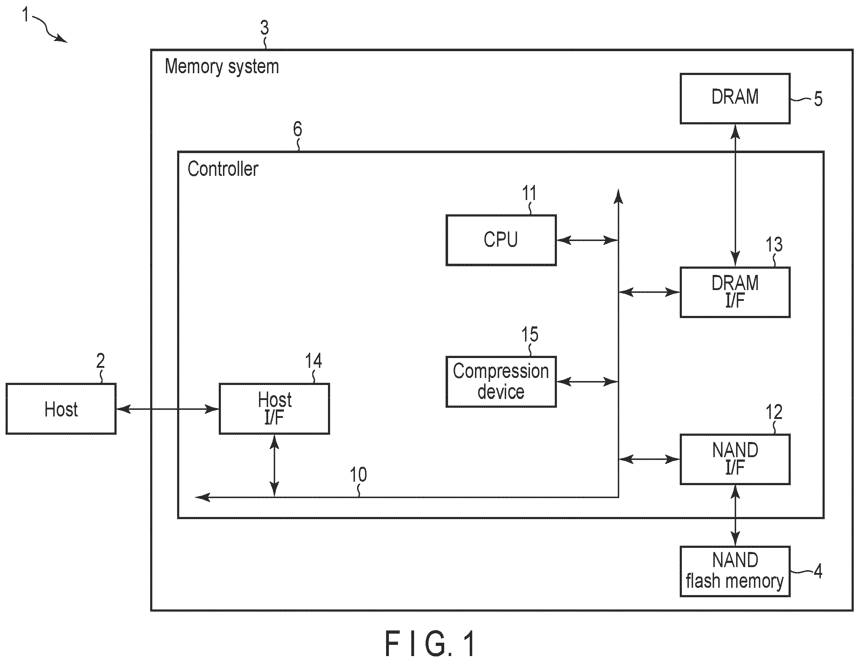

FIG. 1 illustrates an example of a configuration of an information processing system including a compression device according to a first embodiment. An information processing system 1 includes a host device 2 and a memory system 3.

The host device 2 is an information processing device that stores data in the memory system 3. The host device 2 is, for example, a storage server or a personal computer that stores a large amount of various data in the memory system 3. Hereinafter, the host device 2 is referred to as a host 2.

The memory system 3 is a semiconductor storage device configured to write data in a non-volatile memory and read data from the nonvolatile memory. The non-volatile memory is, for example, a NAND flash memory 4. The memory system 3 is realized, for example, as a solid state drive (SSD). Hereinafter, a case where the memory system 3 is realized as the SSD will be exemplified, but the memory system 3 may be realized as a hard disk drive (HDD).

The memory system 3 can be used as a storage of the host 2. The memory system 3 may be built in the host 2 or may be connected to the host 2 via a cable or a network.

An interface for connecting the host 2 and the memory system 3 conforms to standards such as SCSI, Serial Attached SCSI (SAS), AT Attachment (ATA), Serial ATA (SATA), PCI Express (PCIe) (registered trademark), Ethernet (registered trademark), Fibre channel, and NVM Express (NVMe) (registered trademark).

The memory system 3 includes, for example, the NAND flash memory 4, a dynamic random access memory (DRAM) 5, and a controller 6.

The NAND flash memory 4 includes one or more memory chips. Each memory chip includes a plurality of blocks. One block functions as a minimum unit of the data erase operation. The block may also be referred to as an "erasure block" or a "physical block". Each of the plurality of blocks includes a plurality of pages. Each of the plurality of pages includes a plurality of memory cells connected to a single word line. One page functions as a unit of a data write operation and a data read operation. The word line may function as a unit of the data write operation and the data read operation.

The program/erase cycle number (P/E cycle number) for each block has an upper limit and is referred to as a maximum P/E cycle number. One P/E cycle of a certain block includes an erase operation for setting all memory cells in the block to an erase state, and a write operation for writing data to each page of the block.

A DRAM 5 is a volatile memory. The storage area of the DRAM 5 is allocated as, for example, a storage area of firmware (FW), a cache area of a logical-to-physical address conversion table, and a buffer area of user data.

The controller 6 is a memory controller that controls the NAND flash memory 4 and the DRAM 5. The controller 6 is realized by, for example, controller circuitry such as a system-on-a-chip (SoC). The controller 6 may incorporate a static random access memory (SRAM) or DRAM. In this case, the DRAM 5 outside the controller 6 may not be provided.

The controller 6 functions as, for example, a flash translation layer (FTL) configured to execute data management and block management of the NAND flash memory 4. The data management executed by the FTL includes (1) management of mapping information indicating a correspondence relationship between each logical address and each physical address of the NAND flash memory 4, and (2) processing for concealing a difference between the data read operation/data write operation in units of pages and the data erase operation in units of blocks. The block management includes defective block management, wear leveling, and garbage collection.

The logical address is used by the host 2 to address a storage area of the memory system 3. The logical address is, for example, a logical block address (LBA).

The management of mapping between each logical address and each physical address is executed using, for example, the logical-to-physical address conversion table. Using the logical-to-physical address conversion table, the controller 6 manages mapping between each logical address and each physical address in a specific management size unit. A physical address corresponding to a certain logical address indicates a physical storage location in the NAND flash memory 4 to which the user data of the logical address is written. The logical-to-physical address conversion table may be loaded from the NAND flash memory 4 to the DRAM 5 at the time of activation of the memory system 3.

Data can be written to one page only once per P/E cycle. Therefore, the controller 6 writes the update user data corresponding to a certain logical address not to the physical storage location where the previous user data corresponding to this logical address is stored but to another physical storage location. Then, the controller 6 invalidates the previous user data by updating the logical-to-physical address conversion table so as to associate the logical address with another physical storage location.

The controller 6 includes, for example, a CPU 11, a NAND interface (NAND I/F) 12, a DRAM interface (DRAM I/F) 13, a host interface (host I/F) 14, and a compression device 15. The CPU 11, the NAND I/F 12, the DRAM I/F 13, the host I/F 14, and the compression device 15 are connected via, for example, a bus 10.

The CPU 11 is a processor configured to control the NAND I/F 12, the DRAM I/F 13, the host I/F 14, and the compression device 15. The CPU 11 performs various processes by executing the FW loaded from the NAND flash memory 4 into the DRAM 5. The FW is a control program including a command group for causing the CPU 11 to execute various processes. In addition to the FTL processing described above, the CPU 11 executes command processing for processing various commands from the host 2. The operation of the CPU 11 is controlled by the FW executed by the CPU 11. A part or all of the FTL processing and the command processing may be executed by dedicated hardware in the controller 6.

The NAND I/F 12 electrically connects the controller 6 and the NAND flash memory 4. The NAND I/F 12 supports interface standards such as Toggle DDR and Open NAND Flash Interface (ONFI).

The NAND I/F 12 functions as NAND control circuitry configured to control the NAND flash memory 4. The NAND I/F 12 may be connected to a plurality of memory chips in the NAND flash memory 4 via a plurality of channels (Ch). By driving the plurality of memory chips in parallel, access to the entire NAND flash memory 4 can be widened in bandwidth.

The DRAM I/F 13 functions as DRAM control circuitry configured to control access to the DRAM 5.

The host I/F 14 is circuitry that functions as an interface for performing communication between the memory system 3 and the host 2. The host I/F 14 includes circuitry that receives various commands, for example, input/output (I/O) commands and various control commands from the host 2. The I/O command may include a write command and a read command. The control command may include an un-map command (trim command) and a format command. The host I/F 14 includes circuitry that transmits a response or data corresponding to a command to the host 2.

The compression device 15 is encoding circuitry that compresses data by encoding the data to be written to the NAND flash memory 4. For example, the CPU 11 inputs write data received in response to reception of a write command from the host 2 to the compression device 15 as compression target data. The compression device 15 encodes data to be compressed input from the CPU 11. More specifically, the compression device 15 encodes the data to be compressed input from the CPU 11 by a compression algorithm that is a combination of dictionary encoding (for example, LZ77) and entropy encoding (for example, Huffman coding). The data encoded by the compression device 15 is stored in the NAND flash memory 4 as compressed data. When the compressed data is stored in the NAND flash memory 4, predetermined processing such as error correction processing or randomization processing may be executed. In this case, the CPU 11 writes data obtained by executing predetermined processing on the compressed data to the NAND flash memory 4 via the NAND I/F 12. That is, the CPU 11 writes data based on the compressed data to the NAND flash memory 4. In this case, when reading the compressed data from the NAND flash memory 4, the CPU 11 reads data based on a read command from the host 2 from the NAND flash memory 4 via the NAND I/F 12. The data read from the NAND flash memory 4 is subjected to the predetermined processing such as the error correction processing and randomization release processing on the data, and then stored in the DRAM 5 by the CPU 11 as compressed data. The compressed data stored in the DRAM 5 is input to a decompression device (not illustrated) by the CPU 11. The decompression device is built in the controller 6, for example, and decompresses input compressed data to generate decompressed data. That is, the decompression device decompresses the compressed data based on the data read from the NAND flash memory 4 to generate decompressed data.

The components in the compression device 15 are realized by, for example, at least one of a register, a memory, an adder, a multiplier, a selector, and other arithmetic units. The register is realized by, for example, sequential circuit such as a flip-flop. The memory is realized by, for example, a storage element such as SRAM or DRAM. The adder, the multiplier, the selector, and other arithmetic units are realized by, for example, combinational logic circuitry.

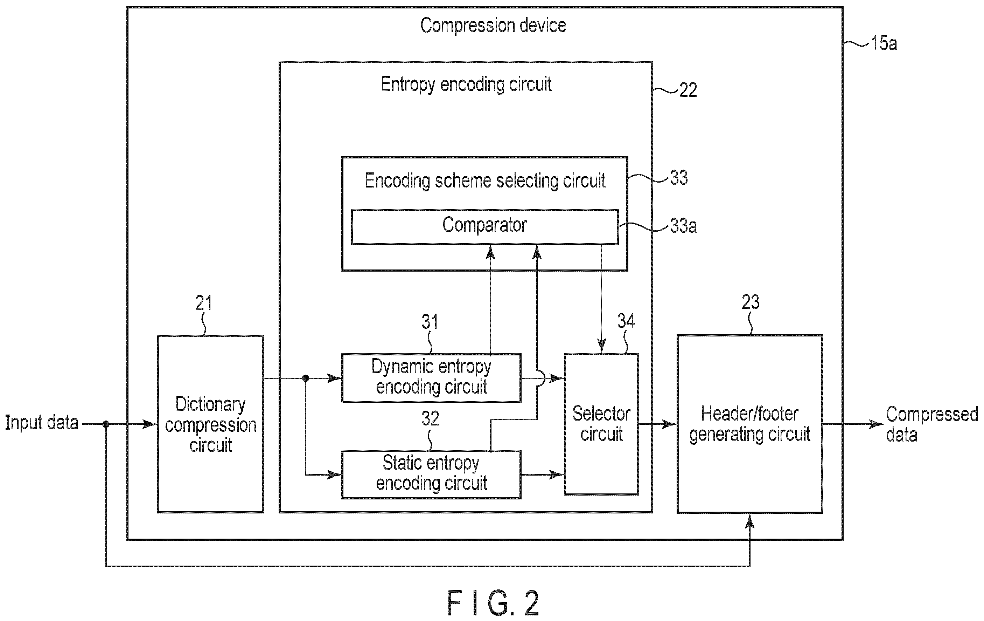

Here, a configuration of a compression device 15a according to a comparative embodiment of the first embodiment will be described with reference to FIG. 2. FIG. 2 is a block diagram illustrating an example of a configuration of the compression device 15a according to a comparative embodiment of the first embodiment. Similarly to the compression device 15 according to the present embodiment, the compression device 15a according to the comparative example is configured to compress data to be compressed input to the compression device 15a by using a compression algorithm that is a combination of dictionary encoding and entropy encoding.

As illustrated in FIG. 2, the compression device 15a includes a dictionary compression circuit 21, an entropy encoding circuit 22, and a header/footer generating circuit 23. The entropy encoding circuit 22 includes a dynamic entropy encoding circuit 31, a static entropy encoding circuit 32, an encoding scheme selecting circuit 33, and a selector circuit 34.

The dictionary compression circuit 21 performs dictionary encoding (dictionary compression) on data to be compressed (input data) input to the compression device 15a. The dictionary encoding is an encoding method for converting data (hereinafter, referred to as dictionary encoding target data) to be subjected to dictionary encoding into a relative reference of data older than the dictionary encoding target data.

Specifically, in the dictionary encoding, a buffer (hereinafter, it is referred to as a history buffer) for storing past data is prepared, and past data matching the dictionary encoding target data is retrieved from the history buffer.

In a case where there is no past data matching the dictionary encoding target data in the history buffer, information (hereinafter, it is referred to as literal information) indicating the dictionary encoding target data is output as a result of the dictionary encoding.

Meanwhile, in a case where past data matching the dictionary encoding target data exists in the history buffer, a set of information (hereinafter, referred to as match length information) indicating a length in which the dictionary encoding target data matches the past data existing in the history buffer and information (hereinafter, referred to as distance information) indicating a position (that is, the distance to the past data in the history buffer) in the history buffer in which the past data is stored is output as a result of the dictionary encoding.

That is, the dictionary compression circuit 21 operates to perform the dictionary encoding using each piece of data partially cut out from the input data as the dictionary encoding target data, and output each of the literal information, the match length information, and the distance information which are the results of the dictionary encoding. Note that the literal information, the match length information, and the distance information may be collectively referred to as "symbols".

The result of the dictionary encoding output from the dictionary compression circuit 21 corresponds to data (hereinafter, referred to as entropy encoding target data) to be subjected to entropy encoding. The entropy encoding target data is data including the plurality of symbols described above, and is input to the entropy encoding circuit 22.

Here, the entropy encoding is an encoding method for converting the symbol to be encoded into an encode word (that is, variable length code) having an encode length according to an appearance frequency of the symbol. The entropy encoding is defined by, for example, deflate or gzip. According to the entropy encoding, the variable length code using the difference in the appearance frequency of the symbol is allocated to the entropy encoding target data including the plurality of symbols, so that the code amount (data amount) can be reduced as a whole.

The entropy encoding includes two schemes, dynamic entropy encoding and static entropy encoding. The dynamic entropy encoding is a scheme in which encoding is performed by dynamically determining an encoding rule and an encoding table according to the input entropy encoding target data. Meanwhile, the static entropy encoding is a scheme of performing encoding based on a predetermined encoding rule and encoding table.

For example, in the case that the Huffman coding is used as the entropy encoding, the dynamic Huffman coding in which the encode tree is changed according to the data to be subjected to the Huffman coding corresponds to the dynamic entropy encoding, and the static Huffman coding in which the encoding is performed using the previously constructed encode tree corresponds to the static entropy encoding.

The dynamic entropy encoding has a feature that high encoding efficiency can be obtained, but the latency is required until the encoding rule and encoding table are dynamically determined. Meanwhile, the static entropy encoding has a feature that the latency required for the encoding is small, but encoding efficiency is low.

The dynamic entropy encoding circuit 31 included in the entropy encoding circuit 22 performs the above-described dynamic entropy encoding on the entropy encoding target data input from the dictionary compression circuit 21.

The static entropy encoding circuit 32 included in the entropy encoding circuit 22 performs the above-described static entropy encoding on the entropy encoding target data input from the dictionary compression circuit 21.

The encoding scheme selecting circuit 33 includes, for example, comparator 33a, and compares the result of the dynamic entropy encoding by the dynamic entropy encoding circuit 31 with the result of the static entropy encoding by the static entropy encoding circuit 32, and outputs an instruction (signal) to select a result of the entropy encoding having a smaller code amount (data amount) to the selector circuit 34.

In accordance with the instruction (signal) from the encoding scheme selecting circuit 33, the selector circuit 34 selects one of the two entropy encoding results output from the dynamic entropy encoding circuit 31 and the static entropy encoding circuit 32, and outputs the selected entropy encoding result to the header/footer generating circuit 23.

The header/footer generating circuit 23 generates a header and a footer to be added to the entropy encoding result (encoded payload) input from the entropy encoding circuit 22. In a case where the result of the entropy encoding input from the entropy encoding circuit 22 is the result of the static entropy encoding, the header includes information indicating the static entropy encoding as the information indicating the implemented entropy encoding scheme. Meanwhile, when the result of the entropy encoding input from the entropy encoding circuit 22 is the result of the dynamic entropy encoding, the header includes information indicating the dynamic entropy encoding as the information indicating the implemented entropy encoding scheme, and further includes the data of the encoding table used for the dynamic entropy encoding. The data of the encoding table is used to restore the encoding table when the compressed data generated by the dynamic entropy encoding is decompressed.

Meanwhile, the footer includes a cyclic redundancy checksum (CRC) calculated based on the input data. The CRC included in the footer is, for example, compared with the CRC of the decompressed data after the decompression of the compressed data, and is used to confirm whether the decompressed data correctly returns to the state of the data (input data) before the compression.

Data including the generated header and footer and the encoded payload corresponding to the result of the entropy encoding is output from the compression device 15a as the compressed data and written to, for example, the NAND flash memory.

As described above, in the compression device 15a according to the comparative example, both the dynamic entropy encoding and the static entropy encoding are performed on the entropy encoding target data, and the result of the entropy encoding having a smaller code amount is selected as the result of the entropy encoding. In this case, from the viewpoint of the encoding efficiency, the result of the dynamic entropy encoding is often selected as the result of the entropy encoding.

However, as described above, the dynamic entropy encoding has the feature that the latency until the encoding rule and the encoding table are dynamically determined increases. Therefore, the when dynamic entropy encoding is performed in a case where the entropy encoding unit, which is a unit of data for which the entropy encoding is performed at a time, is small, the latency until the encoding rule and the encoding table are dynamically determined becomes relatively longer than the latency required for encoding (encoding of the payload) the entropy encoding target data, and the compression throughput decreases.

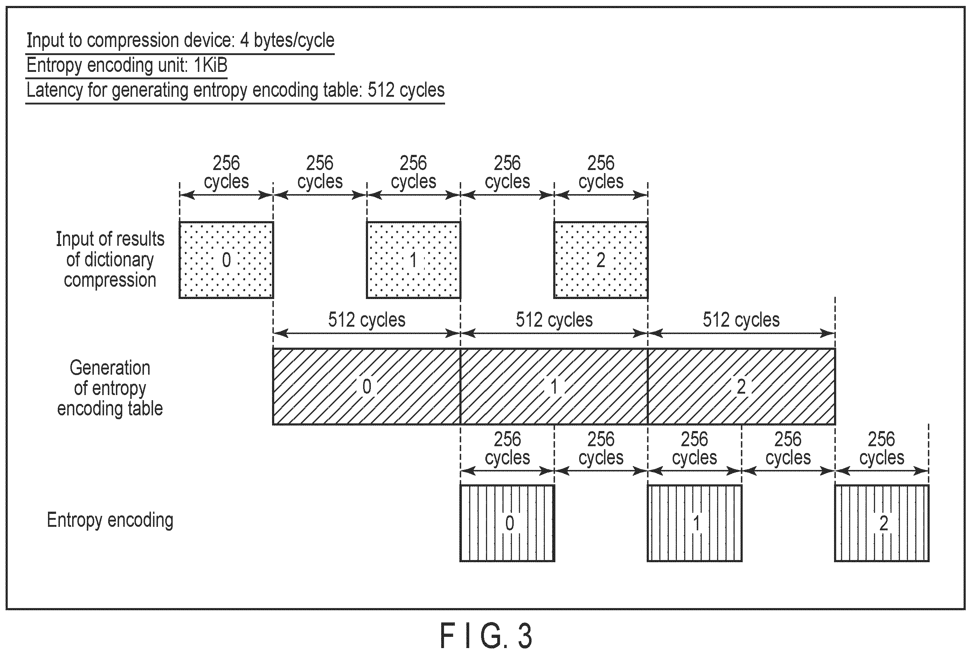

Here, with reference to FIG. 3, an event in which the throughput decreases at the time of the dynamic entropy encoding will be described. FIG. 3 is a diagram for explaining the event in which the throughput decreases at the time of the dynamic entropy encoding.

Here, it is assumed that 4-byte compression target data is input to the compression device 15a every one cycle. Furthermore, here, a case where the entropy encoding unit is 1KiB (that is, 1024 bytes) is assumed. Generally, a compression unit, which is a unit of data to be compressed at a time, is set in the compression device, and the compression unit and the above-described entropy encoding unit are in a relationship of "compression unit ≥ entropy encoding unit". However, here, for ease of description, a case where the compression unit and the entropy encoding unit are in a relationship of "compression unit = entropy encoding unit" is assumed.

Furthermore, here, it is assumed that the latency required for generating the entropy encoding table used for the dynamic entropy encoding is 512 cycles regardless of the size of the entropy encoding unit. That is, here, a case is assumed where the latency required for encoding (encoding of the payload) the entropy encoding target data corresponding to the entropy encoding unit is smaller than the latency required for generating the entropy encoding table.

First, the entropy encoding target data that is the entropy encoding target data of the number "0" illustrated in FIG. 3 and corresponds to the entropy encoding unit of 1KiB is input to the dynamic entropy encoding circuit 31 over 256 cycles.

When the entropy encoding target data corresponding to the entropy encoding unit of 1KiB is input, the dynamic entropy encoding circuit 31 calculates the appearance frequency of each of the plurality of symbols included in the entropy encoding target data, and generates the entropy encoding table optimal for the entropy encoding target data of number "0" based on the distribution of the calculated appearance frequencies.

Thereafter, the dynamic entropy encoding circuit 31 performs the entropy encoding on the input entropy encoding target data by using the generated entropy encoding table.

Here, when the latency (in this case, 512 cycles) for generating the entropy encoding table is relatively longer than the latency (in other words, the latency is the latency required for the input of the entropy encoding target data, and in this case, 256 cycles) for inputting the result of the dictionary compression, as illustrated in FIG. 3, it is necessary to stop the input of the entropy encoding target data until the input of the entropy encoding target data of the number "1" is started after the input of the entropy encoding target data of the number "0" is completed (in this case, it is necessary to stop the input of the entropy encoding target data for 256 cycles).

Note that, although attention is focused on the entropy encoding target data of the number "0" and the number "1", similarly for the entropy encoding target data of the number "1" and the number "2", it is necessary to stop the input of the entropy encoding target data 256 cycles from the completion of the input of the entropy encoding target data of the number "1" to the start of the input of the entropy encoding target data of the number "2". Therefore, the entropy encoding target data is intermittently input, and the compression throughput decreases.

Furthermore, the latency involved in the encoding (encoding of the payload) of the entropy encoding target data performed using the generated entropy encoding table is the same as the latency involved in the input of the entropy encoding target data, and is, for example, 256 cycles.

Therefore, as illustrated in FIG. 3, at the time point when the entropy encoding for the entropy encoding target data of the number "0" is completed, the entropy encoding table corresponding to the entropy encoding target data of the number "1" is not generated, and 256 cycles are left before the entropy encoding for the entropy encoding target data of the number "1" is started.

Similarly, at the time point when the entropy encoding for the entropy encoding target data of the number "1" is completed, the entropy encoding table corresponding to the entropy encoding target data of the number "2" is not generated, and 256 cycles are left before the entropy encoding for the entropy encoding target data of the number "2" is started. Therefore, the output of the entropy encoding result (encoded payload) becomes intermittent, and the compression throughput decreases.

As described above, when the dynamic entropy encoding is performed in a case where the entropy encoding unit is small, the latency required for generating the entropy encoding table cannot be hidden by the latency required for inputting the entropy encoding target data or the latency required for encoding the payload, and the compression throughput decreases. Specifically, in the example of FIG. 3, although the throughput at the time of compression is originally 4 bytes per cycle, the throughput decreases to 2 bytes per cycle.

Note that, although the event in which the throughput decreases at the time of the dynamic entropy encoding has been described here, the throughput may also decrease when decoding the result of the dynamic entropy encoding performed in a case where the entropy encoding unit is small (that is, at the time of dynamic entropy decoding).

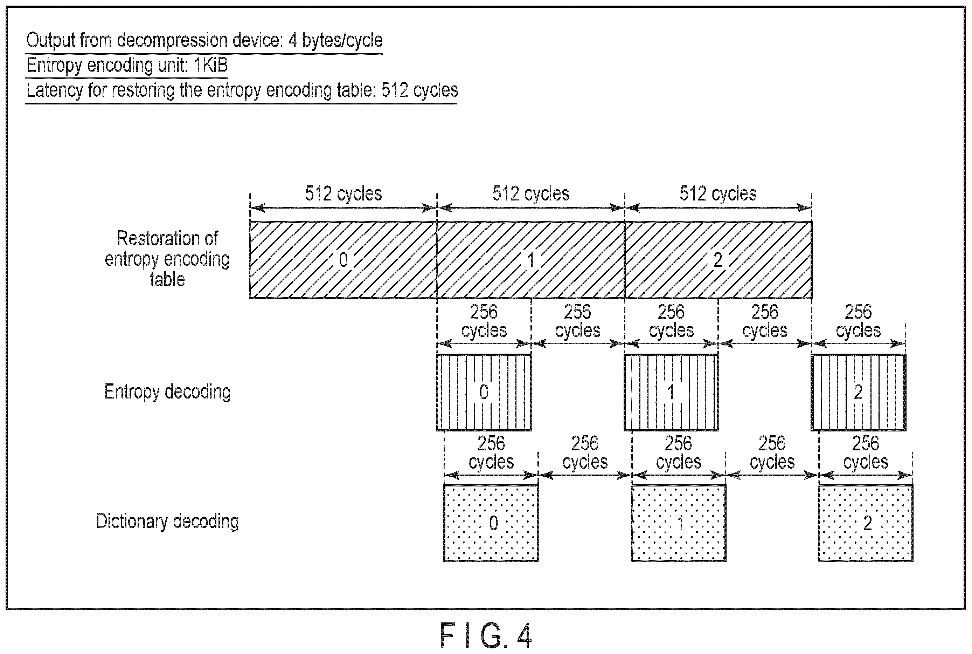

FIG. 4 is a diagram for explaining an event in which throughput decreases at the time of the dynamic entropy decoding. Note that the decoding processing illustrated in FIG. 4 is executed by a decompression device (not illustrated) configured to perform entropy decoding and the dictionary decoding on the result of the entropy decoding.

In addition, here, a case where 4-byte decompressed data is output from the decompression device every cycle is assumed. Furthermore, here, it is assumed that the entropy encoding unit corresponding to the compressed data input to the decompression device is 1KiB. Furthermore, here, it is assumed that the latency required to restore the entropy encoding table from the header included in the compressed data is 512 cycles regardless of the size of the entropy encoding unit. That is, here, it is assumed that the latency required for decoding (decoding the payload) the compressed data corresponding to the entropy encoding unit is smaller than the latency required for restoring the entropy encoding table.

First, when the compressed data of the number "0" (not illustrated) is input, the decompression device restores the entropy encoding table of the number "0" used when the compressed data of the number "0" is encoded based on the header included in the compressed data. Thereafter, the decompression device performs entropy decoding on the input compressed data by using the entropy encoding table of the restored number "0". The result of the entropy decoding is sequentially decoded in a dictionary manner and sequentially output from the decompression device as decompressed data.

The latency required for the decoding of the compressed data (decoding of the payload) performed using the restored entropy encoding table is 256 cycles, and as illustrated in FIG. 4, at the time when the decoding of the compressed data of number "0" is completed, the entropy encoding table of number "1" corresponding to the compressed data of number "1" is not restored, and 256 cycles are left before the entropy decoding for the compressed data of number "1" is started.

As a result, 256 cycles are left from when the decompressed data with the number "0", which is the result of the dictionary decoding, is output from the decompression device to when the decompressed data with the number "1" is output from the decompression device. According to this, the output of the decompressed data becomes intermittent, and the decompression throughput decreases. Specifically, although the throughput at the time of decompression is originally 4 bytes per cycle, the throughput decreases to 2 bytes per cycle.

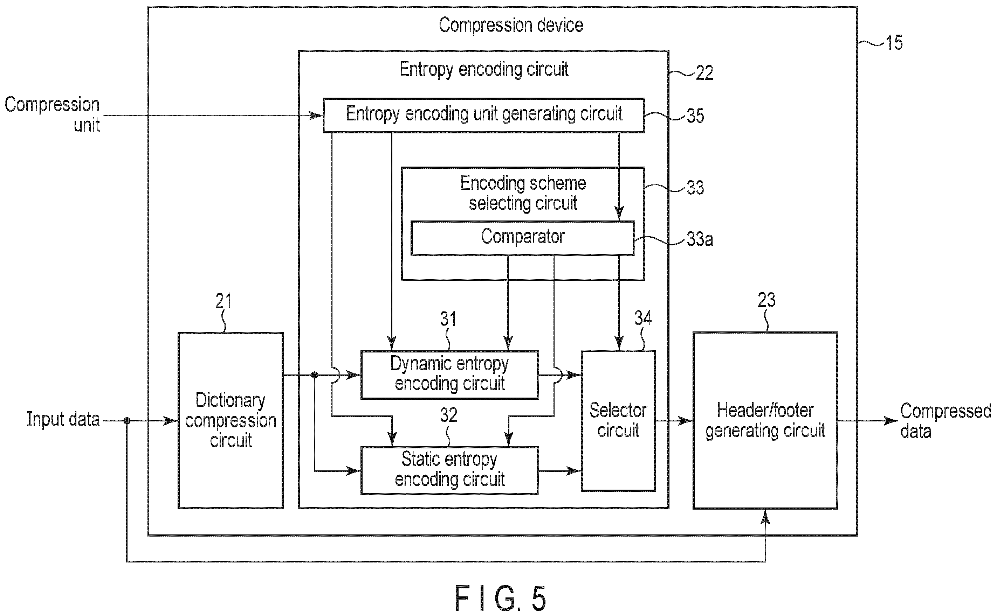

Therefore, as illustrated in FIG. 5, the compression device 15 according to the present embodiment further includes an entropy encoding unit generating circuit 35 in order to realize high encoding efficiency (high compression ratio) while suppressing the decrease in the compression throughput and the decompression throughput described above. Hereinafter, points different from the compression device 15a according to the comparative example will be mainly described, and description of points similar to the compression device 15a according to the comparative example will be omitted.

FIG. 5 is a block diagram illustrating an example of a configuration of the compression device 15 according to the first embodiment.

The entropy encoding unit generating circuit 35 generates at least one entropy encoding unit based on the compression unit designated by CPU 11. The compression unit is a unit of data to be compressed at a time, and corresponds to the size of data to be compressed input to the dictionary compression circuit 21. In the following description, it is assumed that the compression unit and the entropy encoding unit satisfy the relationship of "compression unit ≥ entropy encoding unit". Furthermore, in the present embodiment, it is assumed that the entropy encoding unit generating circuit 35 generates a plurality of entropy encoding units based on the compression unit described above.

The entropy encoding unit group including the plurality of entropy encoding units generated by the entropy encoding unit generating circuit 35 is output to the encoding scheme selecting circuit 33, the dynamic entropy encoding circuit 31, and the static entropy encoding circuit 32.

The encoding scheme selecting circuit 33 selects one of the dynamic entropy encoding or the static entropy encoding as the entropy encoding scheme corresponding to the entropy encoding unit for each of the plurality of entropy encoding units included in the entropy encoding unit group input from the entropy encoding unit generating circuit 35. Although details will be described later, the encoding scheme selecting circuit 33 selects the dynamic entropy encoding when the entropy encoding unit is equal to or more than a predetermined threshold, and selects the static entropy encoding when the entropy encoding unit is less than the threshold.

In a case where the dynamic entropy encoding is selected as the scheme of entropy encoding, the encoding scheme selecting circuit 33 outputs an instruction to perform entropy encoding to the dynamic entropy encoding circuit 31 as an instruction corresponding to the target entropy encoding unit, and outputs an instruction not to perform entropy encoding to the static entropy encoding circuit 32. At this time, the encoding scheme selecting circuit 33 outputs information indicating that the dynamic entropy encoding is selected as the entropy encoding scheme to the selector circuit 34.

Furthermore, in a case where the static entropy encoding is selected as the scheme of entropy encoding, the encoding scheme selecting circuit 33 outputs an instruction to perform entropy encoding to the static entropy encoding circuit 32 and outputs an instruction not to perform entropy encoding to the dynamic entropy encoding circuit 31 as an instruction corresponding to the target entropy encoding unit. At this point, the encoding scheme selecting circuit 33 outputs the information indicating that the static entropy encoding is selected as the scheme of the entropy encoding to the selector circuit 34.

As described above, not only the instruction to perform the entropy encoding but also the instruction not to perform the entropy encoding are output, so that the entropy encoding circuit that has received the instruction not to perform the entropy encoding can recognize that the entropy encoding circuit itself does not need to operate, and power saving can be achieved.

Based on the entropy encoding unit group input from the entropy encoding unit generating circuit 35 and the instruction from the encoding scheme selecting circuit 33, the dynamic entropy encoding circuit 31 and the static entropy encoding circuit 32 perform entropy encoding on the entropy encoding target data, and output the result of the entropy encoding to the selector circuit 34.

The selector circuit 34 recognizes which one of the dynamic entropy encoding circuit 31 and the static entropy encoding circuit 32 outputs the next entropy encoding result based on the information input from the encoding scheme selecting circuit 33, and outputs the entropy encoding result (encoded payload) corresponding to the scheme of the entropy encoding indicated by the information to the header/footer generating circuit 23.

Note that, here, the selector circuit 34 recognizes from which of the dynamic entropy encoding circuit 31 and the static entropy encoding circuit 32 the result of the next entropy encoding is output based on the information input from the encoding scheme selecting circuit 33, and confirms whether the input entropy encoding result is valid data. However, a scheme of confirming whether the input entropy encoding result is valid data is not limited thereto.

For example, when a VALID signal indicating that the entropy encoding result is valid data is added to the entropy encoding result, the selector circuit 34 may check whether the input entropy encoding result is valid data based on the VALID signal. In this case, the encoding scheme selecting circuit 33 can omit outputting the information indicating the scheme of the selected entropy encoding to the selector circuit 34.

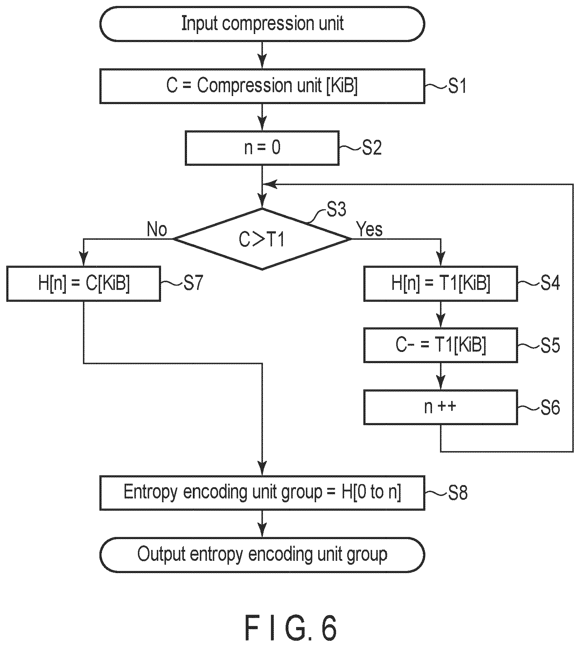

Here, the function of the entropy encoding unit generating circuit 35 will be described in more detail with reference to FIG. 6. FIG. 6 is a flowchart illustrating an example of a procedure of encoding unit generation processing executed by the entropy encoding unit generating circuit 35.

First, upon receiving an input of information indicating the compression unit from the CPU 11, the entropy encoding unit generating circuit 35 executes processing of generating a plurality of entropy encoding units H[n] based on the compression unit indicated by the information. More specifically, the entropy encoding unit generating circuit 35 executes processing of generating a plurality of entropy encoding units H[n] by dividing the above-described compression unit into a size sequentially designated from the head. Note that n represents an integer of 0 or more, and corresponds to the number of times of execution of the processing in Step S3 described later.

Specifically, the entropy encoding unit generating circuit 35 sets the compression unit indicated by the input information as the current compression unit C (Step S1), sets the above-described n to 0 (Step S2), and then repeatedly executes the processing of Steps S3 to S6 described later until the current compression unit C becomes equal to or less than a predetermined threshold T1.

After Step S2 described above, first, the entropy encoding unit generating circuit 35 determines whether the current compression unit C is larger than a predetermined threshold T1 (Step S3). Note that the threshold T1 is set to an arbitrary value designated by the CPU 11, similarly to the above-described compression unit.

In the processing of Step S3, when it is determined that the current compression unit C is larger than the predetermined threshold T1 (Yes in Step S3), the entropy encoding unit generating circuit 35 determines the entropy encoding unit H[n] as the value of the threshold T1 (Step S4).

Thereafter, the entropy encoding unit generating circuit 35 sets a value obtained by subtracting the threshold T1 from the current compression unit C as a new current compression unit C (Step S5), adds 1 to n described above (Step S6), and executes the processing of Step S3 again.

In the processing of Step S3 described above, when it is determined that the current compression unit C is equal to or less than the predetermined threshold T1 (No in Step S3), the entropy encoding unit generating circuit 35 determines the entropy encoding unit H[n] as the value of the current compression unit C (Step S7).

When the entropy encoding unit generating circuit 35 generates an entropy encoding unit group including the plurality of entropy encoding units H[0] to H[n] determined (divided) by the processing in Steps S1 to S7 described above (Step S8), the entropy encoding unit generating unit outputs the entropy encoding unit group to the encoding scheme selecting circuit 33, the dynamic entropy encoding circuit 31, and the static entropy encoding circuit 32, and ends a series of processing.

Here, a specific example of the encoding unit generation processing illustrated in FIG. 6 will be described.

For example, it is assumed that the compression unit indicated by the information input from the CPU 11 is 5KiB and the predetermined threshold T1 is 4KiB. In this case, first, the entropy encoding unit generating circuit 35 sets 5KiB as the current compression unit C in order to generate the first entropy encoding unit H[0], and determines whether the current compression unit C (that is, 5KiB) is larger than 4KiB set as the threshold T1.

In this case, since the current compression unit C is larger than the threshold T1, the entropy encoding unit generating circuit 35 determines the first entropy encoding unit H[0] as 4KiB which is the value of the threshold T1.

Thereafter, the entropy encoding unit generating circuit 35 sets a value obtained by subtracting the threshold T1 from the current compression unit C, that is, 1KiB (=5KiB-4KiB) as a new current compression unit C, and determines whether the new current compression unit C (that is, 1KiB) is larger than 4KiB set as the threshold T1 in order to generate the second entropy encoding unit H[1].

In this case, since the current compression unit C is equal to or less than the threshold T1, the entropy encoding unit generating circuit 35 determines the second entropy encoding unit H[1] as 1KiB which is the value of the current compression unit C.

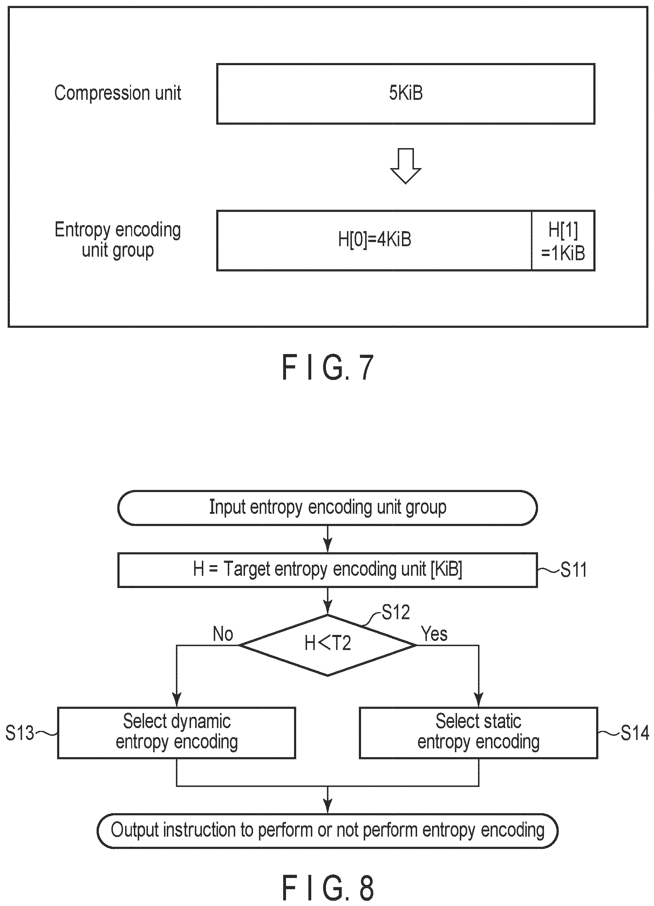

According to this, as illustrated in FIG. 7, the compression unit of 5KiB indicated by the information input from the CPU 11 can be divided into two entropy encoding units of an entropy encoding unit H[0] having a size of 4KiB and an entropy encoding unit H[1] having a size of 1KiB. The entropy encoding unit group including the two entropy encoding units H[0] and H[1] is output to the encoding scheme selecting circuit 33, the dynamic entropy encoding circuit 31, and the static entropy encoding circuit 32.

Next, the function of the encoding scheme selecting circuit 33 will be described in more detail with reference to FIG. 8. FIG. 8 is a flowchart illustrating an example of a procedure of the encoding scheme selection processing executed by the encoding scheme selecting circuit 33.

Upon receiving the input of the entropy encoding unit group from the entropy encoding unit generating circuit 35, the encoding scheme selecting circuit 33 performs the encoding scheme selection processing on each of the plurality of entropy encoding units included in the entropy encoding unit group.

Specifically, first, the encoding scheme selecting circuit 33 sets one of the plurality of entropy encoding units included in the input entropy encoding unit group as a target entropy encoding unit (Step S11), and determines whether the target entropy encoding unit is less than a predetermined threshold T2 (Step S12).

Note that the minimum entropy encoding unit that can hide the latency required for the dynamic entropy encoding circuit 31 to generate the entropy encoding table is set as the threshold T2 (first threshold). More specifically, the entropy encoding unit corresponding to entropy encoding target data required to encode the payload with a latency equal to the latency required for the dynamic entropy encoding circuit 31 to generate the entropy encoding table is set as the threshold T2.

In the processing of Step S12, when it is determined that the target entropy encoding unit is equal to or more than the predetermined threshold T2 (No in Step S12), the encoding scheme selecting circuit 33 selects the dynamic entropy encoding as the entropy encoding scheme corresponding to the target entropy encoding unit (Step S13). In this case, the encoding scheme selecting circuit 33 outputs an instruction to perform entropy encoding to the dynamic entropy encoding circuit 31 as an instruction corresponding to the target entropy encoding unit, and outputs an instruction not to perform entropy encoding to the static entropy encoding circuit 32.

Meanwhile, in the processing of Step S12, when it is determined that the target entropy encoding unit is less than the predetermined threshold T2 (Yes in Step S12), the encoding scheme selecting circuit 33 selects the static entropy encoding as the entropy encoding scheme corresponding to the entropy encoding unit (Step S14). In this case, the encoding scheme selecting circuit 33 outputs an instruction to perform entropy encoding to the static entropy encoding circuit 32 as an instruction corresponding to the target entropy encoding unit, and outputs an instruction not to perform entropy encoding to the dynamic entropy encoding circuit 31.

Here, a specific example of the encoding scheme selection processing illustrated in FIG. 8 will be described.

For example, it is assumed that, as a result of executing the series of processing illustrated in FIG. 6, an entropy encoding unit group including the entropy encoding unit H[0] of 4KiB and the entropy encoding unit H[1] of 1KiB is generated as illustrated in FIG. 7, and the entropy encoding unit group is input to the encoding scheme selecting circuit 33. In this case, the encoding scheme selecting circuit 33 executes the series of processing illustrated in FIG. 8 for each of the entropy encoding units H[0] and H[1] included in the input entropy encoding unit group.

Here, similarly to the case illustrated in FIG. 3, it is assumed that 4-byte compression target data is input to the compression device 15 every cycle. Furthermore, here, similarly to the case illustrated in FIG. 3, it is assumed that the latency required for generating the entropy encoding table used for dynamic entropy encoding is 512 cycles regardless of the size of the entropy encoding unit, and the threshold T2 is set to 2KiB.

In this case, the encoding scheme selecting circuit 33 selects the dynamic entropy encoding for the entropy encoding unit H[0] having a size of 2KiB or more set as the threshold T2, and selects the static entropy encoding for the entropy encoding unit H[1] having a size less than 2KiB set as the threshold T2.

Therefore, the encoding scheme selecting circuit 33 outputs an instruction to perform entropy encoding to the dynamic entropy encoding circuit 31 as an instruction corresponding to the entropy encoding unit H[0], and outputs an instruction not to perform entropy encoding to the static entropy encoding circuit 32. Further, the encoding scheme selecting circuit 33 outputs an instruction to perform entropy encoding to the static entropy encoding circuit 32 and outputs an instruction not to perform entropy encoding to the dynamic entropy encoding circuit 31 as an instruction corresponding to the entropy encoding unit H[1].

Based on the entropy encoding unit group input from the entropy encoding unit generating circuit 35 and the instruction from the encoding scheme selecting circuit 33, the dynamic entropy encoding circuit 31 operates so as to perform the dynamic entropy encoding on entropy encoding target data corresponding to 4KiB from the head of 5KiB of compression target data input to the compression device 15 using the entropy encoding table generated based on the entropy encoding target data and not to perform the dynamic entropy encoding on the entropy encoding target data corresponding to remaining 1KiB of data.

When the entropy encoding unit is 4KiB, the latency required for encoding the payload is 1024 cycles, and the latency required for generating the entropy encoding table (in this case, 512 cycles) can be hidden, so that the throughput during compression is maintained at 4 bytes per cycle.

Meanwhile, based on the entropy encoding unit group input from the entropy encoding unit generating circuit 35 and the instruction from the encoding scheme selecting circuit 33, the static entropy encoding circuit 32 operates so as not to perform the static entropy encoding on the entropy encoding target data corresponding to 4KiB from the head of the compression target data of 5KiB input to the compression device 15, and to perform the static entropy encoding using the entropy encoding table prepared in advance on the entropy encoding target data corresponding to the remaining 1KiB data.

Since the static entropy encoding has no latency to generate the entropy encoding table like the dynamic entropy encoding, even when the entropy encoding unit is small, the compression throughput is not reduced, and the throughput during compression is maintained at 4 bytes per cycle.

As described above, the compression device 15 according to the first embodiment includes the entropy encoding unit generating circuit 35 that generates the plurality of entropy encoding units based on the compression unit, and the encoding scheme selecting circuit 33 that selects the dynamic entropy encoding as the entropy encoding scheme when the entropy encoding unit has the size capable of hiding the latency for generating the entropy encoding table, and selects the static entropy encoding when the entropy encoding unit has the size incapable of hiding the latency.

According to this, dynamic entropy encoding is not performed in a case where the entropy encoding unit is of a size in which the latency required for generating the entropy encoding table cannot be hidden, so that it is possible to suppress a decrease in the compression throughput and decompression throughput as illustrated in FIGS. 3 and 4. That is, the compression device 15 according to the present embodiment can improve the throughput more than the compression device 15a according to the comparative example. Furthermore, in the compression device 15 according to the present embodiment, since the dynamic entropy encoding can be performed as much as possible, high encoding efficiency (high compression ratio) can be realized.

### (Second Embodiment)

Next, a second embodiment will be described. The second embodiment is different from the first embodiment in that the procedure of the encoding unit generation processing executed by the entropy encoding unit generating circuit 35 is different from the procedure illustrated in FIG. 6. Hereinafter, points different from the first embodiment will be mainly described, and description of points similar to the first embodiment will be omitted.

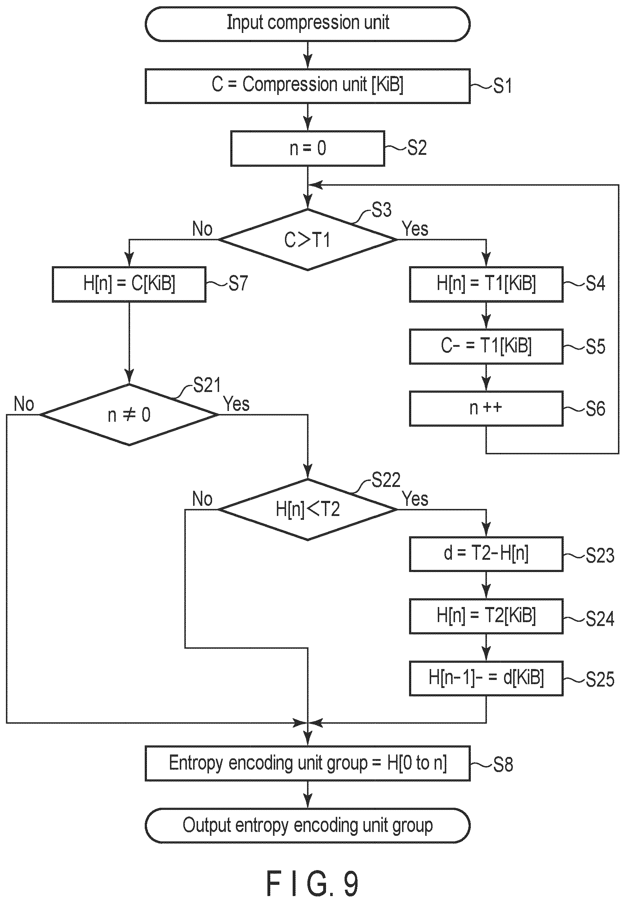

FIG. 9 is a flowchart illustrating an example of a procedure of encoding unit generation processing executed by the entropy encoding unit generating circuit 35 according to the second embodiment. In FIG. 9, processes similar to those illustrated in FIG. 6 are denoted by the same reference numerals, and a detailed description thereof will be omitted here.

First, the entropy encoding unit generating circuit 35 executes processing similar to Steps S1 to S7 illustrated in FIG. 6. After the processing of Step S7 described above, the entropy encoding unit generating circuit 35 determines whether n described above is not 0 (Step S21). When it is determined that n is 0 in the processing of Step S21 (No in Step S21), the entropy encoding unit generating circuit 35 executes the processing of Step S8.

Meanwhile, when it is determined that n is not 0 in the processing of Step S21 (Yes in Step S21), the entropy encoding unit generating circuit 35 determines whether the entropy encoding unit H[n] finally determined (generated) by the processing of Step S7 is less than the threshold T2 (Step S22). When it is determined in the processing of Step S22 that the entropy encoding unit H[n] is equal to or larger than the threshold T2 (No in Step S22), the entropy encoding unit generating circuit 35 executes the processing of Step S8.

Meanwhile, in the processing of Step S22, when it is determined that the entropy encoding unit H[n] is less than the threshold T2 (Yes in Step S22), the entropy encoding unit generating circuit 35 calculates a difference d (that is, a value obtained by subtracting the entropy encoding unit H[n] from the threshold T2) between the entropy encoding unit H[n] and the threshold T2 (Step S23).

Thereafter, the entropy encoding unit generating circuit 35 changes the entropy encoding unit H[n] (first entropy encoding unit) from the current value (first current value) to the value of the threshold T2 (Step S24), changes the entropy encoding unit H[n-1] (second entropy encoding unit) from the current value (second current value) to a value obtained by subtracting the difference d from the current value (second current value) (Step S25), and executes the processing of Step S8.

That is, the processing in Steps S23 to S25 is processing of deleting the difference d from the entropy encoding unit H[n-1] and giving the difference d to the entropy encoding unit H[n], thereby setting both the entropy encoding units H[n-1] and H[n] to values equal to or more than the threshold value T2.

Here, a specific example of the encoding unit generation processing illustrated in FIG. 9 will be described. Note that, in the following, as in the case illustrated in FIG. 3, a case where 4-byte compression target data is input to the compression device 15 every cycle is assumed. Furthermore, in the following description, similarly to the case illustrated in FIG. 3, it is assumed that the latency required for generating the entropy encoding table used for the dynamic entropy encoding is 512 cycles regardless of the size of the entropy encoding unit, and the threshold T2 is set to 2KiB.

For example, when the compression unit indicated by the information input from the CPU 11 is 5KiB and the predetermined threshold value T1 is 4KiB, first, the entropy encoding unit generating circuit 35 sets 5KiB as the current compression unit C in order to generate the first entropy encoding unit H[0], and determines whether the current compression unit C (that is, 5KiB) is larger than 4KiB set as the threshold value T1.

In this case, since the current compression unit C is larger than the threshold T1, the entropy encoding unit generating circuit 35 determines the first entropy encoding unit H[0] as 4KiB which is the value of the threshold T1.

Thereafter, the entropy encoding unit generating circuit 35 sets a value obtained by subtracting the threshold T1 from the current compression unit C, that is, 1KiB (=5KiB-4KiB) as a new current compression unit C, and determines whether the new current compression unit C (that is, 1KiB) is larger than 4KiB set as the threshold T1 in order to generate the second entropy encoding unit H[1].

In this case, since the current compression unit C is equal to or less than the threshold T1, the entropy encoding unit generating circuit 35 determines the second entropy encoding unit H[1] as 1KiB which is the value of the current compression unit C. However, since the entropy encoding unit H[1] determined last is the second entropy encoding unit and n is not 0, the entropy encoding unit generating circuit 35 determines whether the entropy encoding unit H[1] is less than 2KiB set as the threshold T2.

In this case, since the entropy encoding unit H[1] is less than the threshold T2, the entropy encoding unit generating circuit 35 subtracts 1KiB determined as the entropy encoding unit H[1] from 2KiB set as the threshold T2, and calculates the value of 1KiB as the difference d described above.

Thereafter, the entropy encoding unit generating circuit 35 changes the entropy encoding unit H[1] determined last to 2KiB that is the value of the threshold T2 from 1KiB that is the current value, and changes the entropy encoding unit H[0] to 3KiB obtained by subtracting 1KiB calculated as the difference d from 4KiB that is the current value. That is, the entropy encoding unit H[1] is extended to 2KiB, and the entropy encoding unit H[0] is deleted to 3KiB.

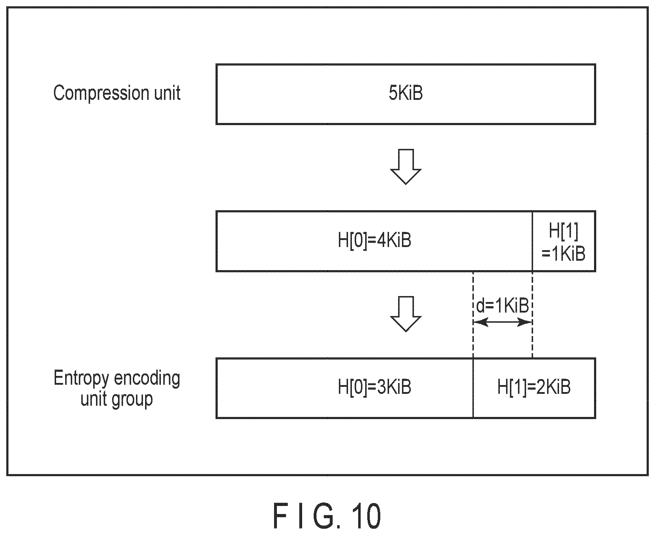

According to this, as illustrated in FIG. 10, the compression unit of 5KiB indicated by the information input from the CPU 11 can be divided into two entropy encoding units of the entropy encoding unit H[0] having a size of 3KiB and the entropy encoding unit H[1] having the size of 2KiB. The entropy encoding unit group including the two entropy encoding units H[0] and H[1] is output to the encoding scheme selecting circuit 33, the dynamic entropy encoding circuit 31, and the static entropy encoding circuit 32.

When receiving the input of the entropy encoding unit group including two entropy encoding units of the entropy encoding unit H[0] having the size of 3KiB and the entropy encoding unit H[1] having the size of 2KiB illustrated in FIG. 10, the encoding scheme selecting circuit 33 executes the encoding scheme selection processing illustrated in FIG. 8 for each of the input entropy encoding units H[0] and H[1].

In this case, the encoding scheme selecting circuit 33 selects the dynamic entropy encoding for both the entropy encoding units H[0] and H[1] having the size of 2KiB or more set as the threshold T2, outputs the instruction to perform the entropy encoding to the dynamic entropy encoding circuit 31 as an instruction common to both the entropy encoding units H[0] and H[1], and outputs the instruction not to perform the entropy encoding to the static entropy encoding circuit 32.

Based on the entropy encoding unit group input from the entropy encoding unit generating circuit 35 and the instruction from the encoding scheme selecting circuit 33, the dynamic entropy encoding circuit 31 performs the dynamic entropy encoding using the first entropy encoding table generated based on the first entropy encoding target data for the first entropy encoding target data corresponding to 3KiB from the head of 5KiB compression target data input to the compression device 15.

Based on the entropy encoding unit group input from the entropy encoding unit generating circuit 35 and the instruction from the encoding scheme selecting circuit 33, the dynamic entropy encoding circuit 31 performs the dynamic entropy encoding using the second entropy encoding table generated based on the second entropy encoding target data for the second entropy encoding target data corresponding to the data of 2KiB from the head of the 5KiB compression target data input to the compression device 15.

When the entropy encoding unit is 3KiB, the latency required for encoding the payload is 768 cycles, and the latency required for generating the entropy encoding table (in this case, 512 cycles) can be hidden, so that the throughput during compression is maintained at 4 bytes per cycle. Furthermore, in a case where the entropy encoding unit is 2KiB, the latency required for encoding the payload is 512 cycles, and the latency required for generating the entropy encoding table (in this case, 512 cycles) can be hidden, so that the throughput during compression is maintained at 4 bytes per cycle.

Note that, in a case where the threshold T1 is 4KiB and the threshold T2 is 2KiB, only in a case where the compression unit is 1KiB, the entropy encoding unit generating circuit 35 generates one (only) entropy encoding unit H[0] having the size of 1KiB, the encoding scheme selecting circuit 33 selects the static entropy encoding, and the static entropy encoding is performed.

As described above, in the compression device 15 according to the second embodiment, the dynamic entropy encoding can be performed on both the entropy encoding target data corresponding to the entropy encoding unit H[0] and the entropy encoding target data corresponding to the entropy encoding unit H[1] while suppressing the decrease in the compression throughput and the decompression throughput. Therefore, higher encoding efficiency (high compression ratio) than that of the compression device 15 according to the first embodiment can be realized.

### (Third Embodiment)

Further, a third embodiment will be described. The third embodiment is different from the second embodiment in that the procedure of the encoding unit generation processing executed by the entropy encoding unit generating circuit 35 is different from the procedure illustrated in FIG. 9. Hereinafter, points different from the second embodiment will be mainly described, and description of points similar to the second embodiment will be omitted.

Here, first, the relationship between the size of the entropy encoding unit and the encoding efficiency will be described. When the dynamic entropy encoding is performed in a case where the entropy encoding unit is small, the data size of the entropy encoding table added as a header is relatively large with respect to the data size of the encoded payload (that is, the overhead increases), and encoding efficiency may be reduced. As described above, when the entropy encoding unit is smaller than the predetermined size, the static entropy encoding may have higher encoding efficiency than the dynamic entropy encoding.

In the encoding unit generation processing illustrated in FIG. 9, while the entropy encoding unit H[n] determined last is extended, the entropy encoding unit H[n-1] determined immediately before is deleted. Therefore, both the entropy encoding units H[n-1] and H[n] can be set to be equal to or more than the value of the threshold T2, but the encoding efficiency may not be so high due to the relationship between the size of the entropy encoding unit and the encoding efficiency described above.

Therefore, in the present embodiment, when the entropy encoding unit H[n] determined last is very small, and there is a possibility that the encoding efficiency does not become so high even when both the entropy encoding units H[n-1] and H[n] are made equal to or more than the value of the threshold T2, the entropy encoding unit H[n] is not changed (extended).

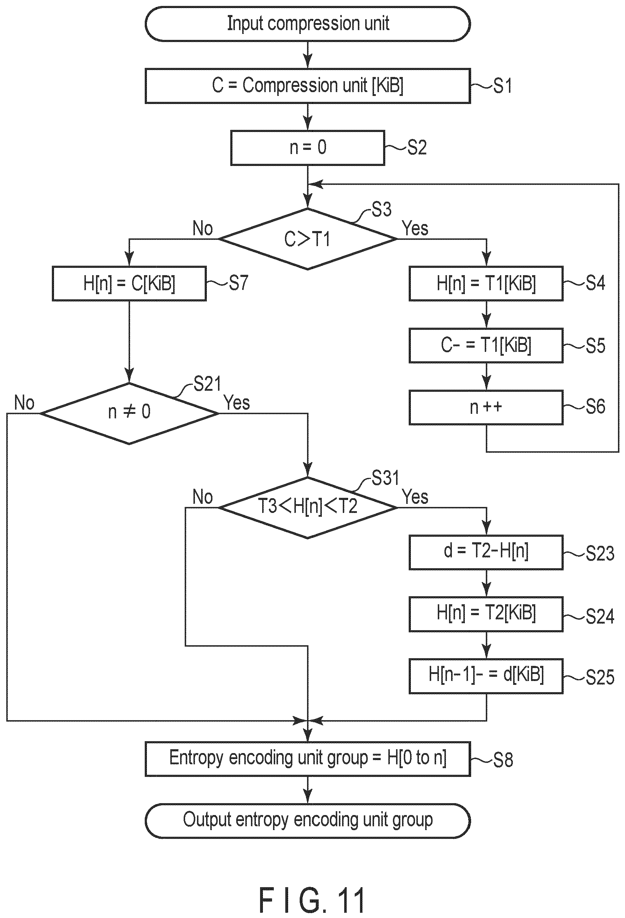

FIG. 11 is a flowchart illustrating an example of a procedure of encoding unit generation processing executed by the entropy encoding unit generating circuit 35 according to the third embodiment. In FIG. 11, processes similar to those illustrated in FIG. 9 are denoted by the same reference numerals, and a detailed description thereof will be omitted here.

First, the entropy encoding unit generating circuit 35 executes processing similar to Steps S1 to S7 and S21 illustrated in FIG. 9. In the processing of Step S21, when it is determined that n is not 0 (Yes in Step S21), the entropy encoding unit generating circuit 35 determines whether the entropy encoding unit H[n] last determined by the processing of Step S7 is larger than the threshold T3 and less than the threshold T2. In other words, the entropy encoding unit generating circuit 35 determines whether the entropy encoding unit H[n] determined last satisfies the condition of "T3 (first threshold) < H[n] <T2 (second threshold)" (Step S31).

In the processing of Step S31, when it is determined that the entropy encoding unit H[n] is larger than the threshold T3 and smaller than the threshold T2 (Yes in Step S31), the entropy encoding unit generating circuit 35 executes processing similar to Steps S23 to S25 illustrated in FIG. 9, extends the entropy encoding unit H[n] (first entropy encoding unit) to the threshold T2, and deletes the difference d from the entropy encoding unit H[n-1] (second entropy encoding unit).

Meanwhile, in the processing of Step S31, when it is determined that the entropy encoding unit H[n] is less than the threshold T3 (No in Step S31), the entropy encoding unit generating circuit 35 executes the processing of Step S8 without extending the entropy encoding unit H[n].

Note that the threshold value T3 is an entropy encoding unit of which the encoding efficiency is expected not to be much higher even when the entropy encoding unit H[n] is extended to the threshold value T2 by the processing of Steps S23 to S25 and both the entropy encoding units H[n-1] and H[n] are set to values equal to or more than the threshold value T2.

Here, a specific example of the encoding unit generation processing illustrated in FIG. 11 will be described. Note that, in the following, as in the case illustrated in FIG. 3, a case where 4-byte compression target data is input to the compression device 15 every cycle is assumed. Furthermore, in the following description, similarly to the case illustrated in FIG. 3, it is assumed that the latency required for generating the entropy encoding table used for the dynamic entropy encoding is 512 cycles regardless of the size of the entropy encoding unit, and the threshold T2 is set to 2KiB. Furthermore, here, it is assumed that the threshold T3 is set to 512 bytes.

For example, when the compression unit indicated by the information input from the CPU 11 is 4.1KiB and the predetermined threshold value T1 is 4KiB, first, the entropy encoding unit generating circuit 35 sets 4.1KiB as the current compression unit C in order to generate the first entropy encoding unit H[0], and determines whether the current compression unit C (that is, 4.1KiB) is larger than 4KiB set as the threshold value T1.

In this case, since the current compression unit C is larger than the threshold T1, the entropy encoding unit generating circuit 35 determines the first entropy encoding unit H[0] as 4KiB which is the value of the threshold T1.

Thereafter, the entropy encoding unit generating circuit 35 sets a value obtained by subtracting the threshold T1 from the current compression unit C, that is, 0.1KiB (=4.1KiB-4KiB) as a new current compression unit C, and determines whether the new current compression unit C (that is, 0.1KiB) is larger than 4KiB set as the threshold T1 in order to generate the second entropy encoding unit H[1].

In this case, since the current compression unit C is equal to or less than the threshold T1, the entropy encoding unit generating circuit 35 determines the second entropy encoding unit H[1] to be 0.1KiB which is the value of the current compression unit C. However, since the entropy encoding unit H[1] determined last is the second entropy encoding unit and n is not 0, the entropy encoding unit generating circuit 35 determines whether the entropy encoding unit H[1] is larger than 512 bytes set as the threshold T3 and less than 2KiB set as the threshold T2.

In this case, since the entropy encoding unit H[1] is less than the threshold T3, the entropy encoding unit generating circuit 35 outputs the entropy encoding unit group including the entropy encoding unit H[0] having the size of 4KiB and the entropy encoding unit H[1] having the size of 0.1KiB to the encoding scheme selecting circuit 33, the dynamic entropy encoding circuit 31, and the static entropy encoding circuit 32 without changing (extending) the entropy encoding unit H[1].

When receiving the input of the entropy encoding unit group including two entropy encoding units of the entropy encoding unit H[0] having the size of 4KiB and the entropy encoding unit H[1] having the size of 0.1KiB, the encoding scheme selecting circuit 33 executes the encoding scheme selection processing illustrated in FIG. 8 for each of the input entropy encoding units H[0] and H[1].

In this case, the encoding scheme selecting circuit 33 selects the dynamic entropy encoding for the entropy encoding unit H[0] having a size of 2KiB or more set as the threshold T2, and selects the static entropy encoding for the entropy encoding unit H[1] having a size less than 2KiB set as the threshold T2.

Therefore, the encoding scheme selecting circuit 33 outputs an instruction to perform entropy encoding to the dynamic entropy encoding circuit 31 as an instruction corresponding to the entropy encoding unit H[0], and outputs an instruction not to perform entropy encoding to the static entropy encoding circuit 32. Further, the encoding scheme selecting circuit 33 outputs an instruction to perform entropy encoding to the static entropy encoding circuit 32 and outputs an instruction not to perform entropy encoding to the dynamic entropy encoding circuit 31 as an instruction corresponding to the entropy encoding unit H[1].

Based on the entropy encoding unit group input from the entropy encoding unit generating circuit 35 and the instruction from the encoding scheme selecting circuit 33, the dynamic entropy encoding circuit 31 operates so as to perform the dynamic entropy encoding using the entropy encoding table generated based on the entropy encoding target data for the entropy encoding target data corresponding to 4KiB from the head of the 4.1KiB compression target data input to the compression device 15 and not to perform the entropy encoding on the entropy encoding target data corresponding to the remaining 0.1KiB data.

When the entropy encoding unit is 4KiB, the latency required for encoding the payload is 1024 cycles, and the latency required for generating the entropy encoding table (in this case, 512 cycles) can be hidden, so that the throughput during compression is maintained at 4 bytes per cycle.

Meanwhile, based on the entropy encoding unit group input from the entropy encoding unit generating circuit 35 and the instruction from the encoding scheme selecting circuit 33, the static entropy encoding circuit 32 operates so as not to perform entropy encoding on entropy encoding target data corresponding to 4KiB from the head of compression target data of 4.1KiB input to the compression device 15, and to perform the static entropy encoding using an entropy encoding table prepared in advance on entropy encoding target data corresponding to remaining 0.1KiB data.

Since the static entropy encoding has no latency to generate the entropy encoding table like the dynamic entropy encoding, even when the entropy encoding unit is small, the compression throughput is not reduced, and the throughput during compression is maintained at 4 bytes per cycle.

As described above, in the compression device 15 according to the third embodiment, in addition to the effects of the second embodiment described above, it is possible to suppress a decrease in encoding efficiency due to the overhead of the entropy encoding table added as a header.

According to at least one embodiment described above, it is possible to provide a compression device, a memory system, and an information processing system capable of improving throughput.

The arrangements or embodiments as described above are in accordance with the following numbered clauses.

### Clause 1

A compression device (15) that compresses data of a size corresponding to a compression unit (C), the compression device (15) comprising
circuitry (22) configured to:
generate an entropy encoding unit (H[n]) that is a unit of data to be subjected to entropy encoding at a time based on the compression unit (C);
select one of dynamic entropy encoding and static entropy encoding as a scheme of entropy encoding performed on data corresponding to the entropy encoding unit (H[n]) based on the entropy encoding unit (H[n]);
perform the dynamic entropy encoding on entropy encoding target data that is a target of the entropy encoding when the dynamic entropy encoding is selected; and
perform the static entropy encoding on the entropy encoding target data when the static entropy encoding is selected.

### Clause 2

The compression device (15) of Clause 1, wherein the circuitry (22) is configured to generate a plurality of entropy encoding units (H[0 to n]) by dividing the compression unit (C) into a size sequentially designated from a head.

### Clause 3

The compression device (15) of Clause 2, wherein when a first entropy encoding unit (H[n]) generated last among the entropy encoding units (H[0 to n]) is less than a first threshold (T2), the circuitry (22) is configured to calculate a difference (d) between the first entropy encoding unit (H[n]) and the first threshold (T2), change the first entropy encoding unit (H[n]) from a first current value to a value of the first threshold (T2), and change a second entropy encoding unit (H[n-1]) generated immediately before the first entropy encoding unit (H[n]) from a second current value to a value obtained by subtracting the difference (d) from the second current value.

### Clause 4

The compression device (15) of Clause 3, wherein the first threshold (T2) is a value corresponding to latency required for generating an entropy encoding table.

### Clause 5

The compression device (15) of Clause 2, wherein when a first entropy encoding unit (H[n]) generated last among the entropy encoding units (H[0 to n]) is larger than a first threshold (T3) and less than a second threshold (T2) different from the first threshold (T3), the circuitry (22) is configured to calculate a difference (d) between the first entropy encoding unit (H[n]) and the second threshold (T2), change the first entropy encoding unit (H[n]) from a first current value to a value of the second threshold (T2), and change a second entropy encoding unit (H[n-1]) generated immediately before the first entropy encoding unit (H[n]) from a second current value to a value obtained by subtracting the difference (d) from the second current value.

### Clause 6

The compression device (15) of Clause 5, wherein the second threshold (T2) is a value corresponding to latency required for generating an entropy encoding table.

### Clause 7

The compression device (15) of any one of Clauses 1 to 6, wherein the circuitry (22) is configured to compare the entropy encoding unit (H[n]) with a predetermined threshold (T2), select the dynamic entropy encoding as the entropy encoding scheme when the entropy encoding unit (H[n]) is equal to or more than the predetermined threshold (T2), and select the static entropy encoding as the entropy encoding scheme when the entropy encoding unit (H[n]) is less than the predetermined threshold (T2).

### Clause 8

The compression device (15) of Clause 7, wherein the predetermined threshold (T2) is a value corresponding to latency required for generating an entropy encoding table.

### Clause 9

A memory system (3) comprising:
a non-volatile memory (4); and
a controller (6) including a compression device (15) that compresses data of a size corresponding to a compression unit (C), the controller (6) being configured to write, compressed data including data entropy encoded by the compression device (15), into the non-volatile memory (4), wherein
the compression device (15) comprises circuitry (22) configured to:
   generate an entropy encoding unit (H[n]) that is a unit of data to be subjected to entropy encoding at a time based on the compression unit (C);
   select one of dynamic entropy encoding and static entropy encoding as a scheme of entropy encoding performed on data corresponding to the entropy encoding unit (H[n]) based on the entropy encoding unit (H[n]);
   perform the dynamic entropy encoding on entropy encoding target data that is a target of the entropy encoding when the dynamic entropy encoding is selected; and
   perform the static entropy encoding on the entropy encoding target data when the static entropy encoding is selected.

### Clause 10

The memory system (3) of Clause 9, wherein the circuitry (22) of the compression device (15) is configured to generate a plurality of entropy encoding units (H[0 to n]) by dividing the compression unit (C) into a size sequentially designated from a head.

### Clause 11

The memory system (3) of Clause 10, wherein when a first entropy encoding unit (H[n]) generated last among the entropy encoding units (H[0 to n]) is less than a first threshold (T2), the circuitry (22) of the compression device (15) is configured to calculate a difference (d) between the first entropy encoding unit (H[n]) and the first threshold (T2), change the first entropy encoding unit (H[n]) from a first current value to a value of the first threshold (T2), and change a second entropy encoding unit (H[n-1]) generated immediately before the first entropy encoding unit (H[n]) from a second current value to a value obtained by subtracting the difference (d) from the second current value.

### Clause 12

The memory system (3) of Clause 11, wherein the first threshold (T2) is a value corresponding to latency required for generating an entropy encoding table.

### Clause 13

The memory system (3) of Clause 10, wherein when a first entropy encoding unit (H[n]) generated last among the entropy encoding units (H[0 to n]) is larger than a first threshold (T3) and less than a second threshold (T2) different from the first threshold (T3), the circuitry (22) of the compression device (15) is configured to calculate a difference (d) between the first entropy encoding unit (H[n]) and the second threshold (T2), change the first entropy encoding unit (H[n]) from a first current value to a value of the second threshold (T2), and change a second entropy encoding unit (H[n-1]) generated immediately before the first entropy encoding unit (H[n]) from a second current value to a value obtained by subtracting the difference (d) from the second current value.

### Clause 14

The memory system (3) of Clause 13, wherein the second threshold (T2) is a value corresponding to latency required for generating an entropy encoding table.

### Clause 15

The memory system (3) of any one of Clauses 9 to 14, wherein the circuitry (22) of the compression device (15) is configured to compare the entropy encoding unit (H[n]) with a predetermined threshold (T2), select the dynamic entropy encoding as the entropy encoding scheme when the entropy encoding unit (H[n]) is equal to or more than the predetermined threshold (T2), and select the static entropy encoding as the entropy encoding scheme when the entropy encoding unit (H[n]) is less than the predetermined threshold (T2).

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the scope of the inventions. The accompanying claims are intended to cover such forms or modification as would fall within the scope of the inventions.

## Claims

1. A compression device (15) that compresses data of a size corresponding to a compression unit (C), the compression device (15) comprising
circuitry (22) configured to:
generate an entropy encoding unit (H[n]) that is a unit of data to be subjected to entropy encoding at a time based on the compression unit (C);
select one of dynamic entropy encoding and static entropy encoding as a scheme of entropy encoding performed on data corresponding to the entropy encoding unit (H[n]) based on the entropy encoding unit (H[n]);
perform the dynamic entropy encoding on entropy encoding target data that is a target of the entropy encoding when the dynamic entropy encoding is selected; and
perform the static entropy encoding on the entropy encoding target data when the static entropy encoding is selected.

2. The compression device (15) of claim 1, wherein the circuitry (22) is configured to generate a plurality of entropy encoding units (H[0 to n]) by dividing the compression unit (C) into a size sequentially designated from a head.

3. The compression device (15) of claim 2, wherein when a first entropy encoding unit (H[n]) generated last among the entropy encoding units (H[0 to n]) is less than a first threshold (T2), the circuitry (22) is configured to calculate a difference (d) between the first entropy encoding unit (H[n]) and the first threshold (T2), change the first entropy encoding unit (H[n]) from a first current value to a value of the first threshold (T2), and change a second entropy encoding unit (H[n-1]) generated immediately before the first entropy encoding unit (H[n]) from a second current value to a value obtained by subtracting the difference (d) from the second current value.

4. The compression device (15) of claim 3, wherein the first threshold (T2) is a value corresponding to latency required for generating an entropy encoding table.

5. The compression device (15) of claim 2, wherein when a first entropy encoding unit (H[n]) generated last among the entropy encoding units (H[0 to n]) is larger than a first threshold (T3) and less than a second threshold (T2) different from the first threshold (T3), the circuitry (22) is configured to calculate a difference (d) between the first entropy encoding unit (H[n]) and the second threshold (T2), change the first entropy encoding unit (H[n]) from a first current value to a value of the second threshold (T2), and change a second entropy encoding unit (H[n-1]) generated immediately before the first entropy encoding unit (H[n]) from a second current value to a value obtained by subtracting the difference (d) from the second current value.

6. The compression device (15) of claim 5, wherein the second threshold (T2) is a value corresponding to latency required for generating an entropy encoding table.

7. The compression device (15) of any preceding claim, wherein the circuitry (22) is configured to compare the entropy encoding unit (H[n]) with a predetermined threshold (T2), select the dynamic entropy encoding as the entropy encoding scheme when the entropy encoding unit (H[n]) is equal to or more than the predetermined threshold (T2), and select the static entropy encoding as the entropy encoding scheme when the entropy encoding unit (H[n]) is less than the predetermined threshold (T2).

8. The compression device (15) of claim 7, wherein the predetermined threshold (T2) is a value corresponding to latency required for generating an entropy encoding table.

9. A memory system (3) comprising:
a non-volatile memory (4); and
a controller (6) including a compression device (15) that compresses data of a size corresponding to a compression unit (C), the controller (6) being configured to write, compressed data including data entropy encoded by the compression device (15), into the non-volatile memory (4), wherein
the compression device (15) comprises circuitry (22) configured to:
generate an entropy encoding unit (H[n]) that is a unit of data to be subjected to entropy encoding at a time based on the compression unit (C);
select one of dynamic entropy encoding and static entropy encoding as a scheme of entropy encoding performed on data corresponding to the entropy encoding unit (H[n]) based on the entropy encoding unit (H[n]);
perform the dynamic entropy encoding on entropy encoding target data that is a target of the entropy encoding when the dynamic entropy encoding is selected; and
perform the static entropy encoding on the entropy encoding target data when the static entropy encoding is selected.

10. The memory system (3) of claim 9, wherein the circuitry (22) of the compression device (15) is configured to generate a plurality of entropy encoding units (H[0 to n]) by dividing the compression unit (C) into a size sequentially designated from a head.

11. The memory system (3) of claim 10, wherein when a first entropy encoding unit (H[n]) generated last among the entropy encoding units (H[0 to n]) is less than a first threshold (T2), the circuitry (22) of the compression device (15) is configured to calculate a difference (d) between the first entropy encoding unit (H[n]) and the first threshold (T2), change the first entropy encoding unit (H[n]) from a first current value to a value of the first threshold (T2), and change a second entropy encoding unit (H[n-1]) generated immediately before the first entropy encoding unit (H[n]) from a second current value to a value obtained by subtracting the difference (d) from the second current value.

12. The memory system (3) of claim 11, wherein the first threshold (T2) is a value corresponding to latency required for generating an entropy encoding table.

13. The memory system (3) of claim 10, wherein when a first entropy encoding unit (H[n]) generated last among the entropy encoding units (H[0 to n]) is larger than a first threshold (T3) and less than a second threshold (T2) different from the first threshold (T3), the circuitry (22) of the compression device (15) is configured to calculate a difference (d) between the first entropy encoding unit (H[n]) and the second threshold (T2), change the first entropy encoding unit (H[n]) from a first current value to a value of the second threshold (T2), and change a second entropy encoding unit (H[n-1]) generated immediately before the first entropy encoding unit (H[n]) from a second current value to a value obtained by subtracting the difference (d) from the second current value.

14. The memory system (3) of claim 13, wherein the second threshold (T2) is a value corresponding to latency required for generating an entropy encoding table.

15. The memory system (3) of any one of claims 9 to 14, wherein the circuitry (22) of the compression device (15) is configured to compare the entropy encoding unit (H[n]) with a predetermined threshold (T2), select the dynamic entropy encoding as the entropy encoding scheme when the entropy encoding unit (H[n]) is equal to or more than the predetermined threshold (T2), and select the static entropy encoding as the entropy encoding scheme when the entropy encoding unit (H[n]) is less than the predetermined threshold (T2).
